# EUROPÄISCHE PATENTSCHRIFT

(11) **EP 2 373 145 B1**
(45) Veröffentlichungstag und Bekanntmachung des Hinweises auf die Patenterteilung: **10.05.2017**
(21) Anmeldenummer: 11002394.2
(22) Anmeldetag: 23.03.2011
(51) Int. Cl.: H05K 13/04, H05K 13/08

(54) **Vorrichtung zum Erfassen eines sich bewegenden Objektes**
Device for measuring a moving object
Dispositif de mesure d'un objet se déplacant

(30) Priorität: 31.03.2010 DE 102010013505
(43) Veröffentlichungstag der Anmeldung: 05.10.2011
(73) Patentinhaber: MIMOT GmbH, 79539 Lörrach (DE)
(72) Erfinder: Hug, Karl, 79777 Ühlingen-Birkendorf (DE)
(74) Vertreter: Dimmerling & Huwer

(56) Entgegenhaltungen:
- EP-A1- 0 449 481
- EP-A1- 1 916 887
- WO-A1-2004/064472
- US-A- 5 541 834
- US-A- 5 878 484
- US-A1- 2008 083 114
- US-B1- 6 359 646

## Beschreibung

Die Erfindung betrifft eine Vorrichtung nach dem Oberbegriff des Anspruchs 1, zum Erfassen eines auf einem verstellbaren Träger angeordneten Objektes, welche eine Bildaufnahmeeinrichtung zur Aufnahme des Objekts aufweist.

Eine derartige Vorrichtung ist aus EP 0 449 481 A1, US 2008/083114 A1, WO 2004/064472 A1, US 5 878 484 A, US 5 541 843 A, US 6 359 646 B1 und EP 1 916 887 A1 bekannt und wird unter anderem zur Positionserfassung und/oder Lageerkennung von Werkstücken oder Bauelementen in Montageautomaten sowie bei der Bestückung von Leiterplatten mit elektronischen Bauelementen verwendet.

Insbesondere bei der Bestückung von Leiterplatten mit elektronischen Bauelementen ist es von besonderer Bedeutung, dass die Bauelemente in einer exakten Position sowie Lage auf die Leiterplatte aufgebracht werden. Hierzu wird die Position sowie Lage eines betreffenden Bauelements relativ zu dem Greifer erfasst, mittels dem es auf die Leiterplatte aufgebracht wird.

Durch die Erfassung der Position und Lage des Bauelements im Greifer ist es möglich, den Greifer derart zu verstellen, dass das Bauelement positionsgenau und lagerichtig auf die Leiterplatte abgesetzt wird. Die Verstellung des Greifers erfolgt aufgrund von üblicherweise mittels einer Kamera, welche ein als Halbleiterchip ausgebildetes Bildaufnahmeelement sowie eine Linse enthält, erfassten Koordinaten. Aufgrund der erfassten Koordinaten kann in einer Steuerung durch Vergleich der erfassten Koordinaten mit betreffenden Sollkoordinaten die erforderliche Verstellung des Greifers berechnet werden.

Zur Erfassung der Position sowie Lage des Bauelements in dem Greifer fährt der Greifer nach dem Aufnehmen des Bauelements aus einer Vorratseinrichtung zunächst über eine Kamera. Die Kamera erfasst die Position sowie Lage des Teils und gibt die betreffenden Koordinaten an die Steuerung weiter, die die Daten dann entsprechend auswertet. Ist das Bauelement nicht exakt in seiner Sollposition und -lage in dem Greifer angeordnet, werden in der Steuerung Korrekturwerte berechnet, um die der Greifer das Bauelement dann versetzt auf die Leiterplatte aufbringt.

Wenngleich mittels der bekannten Vorrichtung elektronische Bauelemente beziehungsweise Werkstücke in einer im Wesentlichen exakten Position und Lage von dem Greifer abgegeben werden können, so lässt sich die Genauigkeit der Vorrichtung dennoch verbessern. Denn dadurch, dass sich die Bauelemente beziehungsweise Werkstücke bei ihrer Erfassung relativ zur Kamera bewegen, entstehen je nach Belichtungszeit unscharfe Kanten des Bauelements beziehungsweise des Werkstückes. Dies wiederum führt dazu, dass die erfasste Position beziehungsweise Lage des Bauelements beziehungsweise Werkstücks im Bereich der Unschärfe der Kanten variiert. Hierdurch besitzen die Korrekturwerte eine entsprechend begrenzte Genauigkeit.

Es ist Aufgabe der Erfindung eine Eingangs genannte Vorrichtung derart auszubilden, dass sie zur exakten Erfassung der Position beziehungsweise Lage eines Objektes bei großer Belichtungszeit geeignet ist.

Die Lösung dieser Aufgabe ergibt sich aus den Merkmalen des kennzeichnenden Teils des Anspruchs 1. Vorteilhafte Weiterbildungen der Erfindung ergeben sich aus den Unteransprüchen.

Gemäß der Erfindung ist eine Vorrichtung zum Erfassen eines auf einem verstellbaren Träger angeordneten Objektes, welche eine Bildaufnahmeeinrichtung zur Aufnahme des Objektes aufweist, dadurch gekennzeichnet, dass die Bildaufnahmeeinrichtung synchron mit dem Träger verstellbar ist.

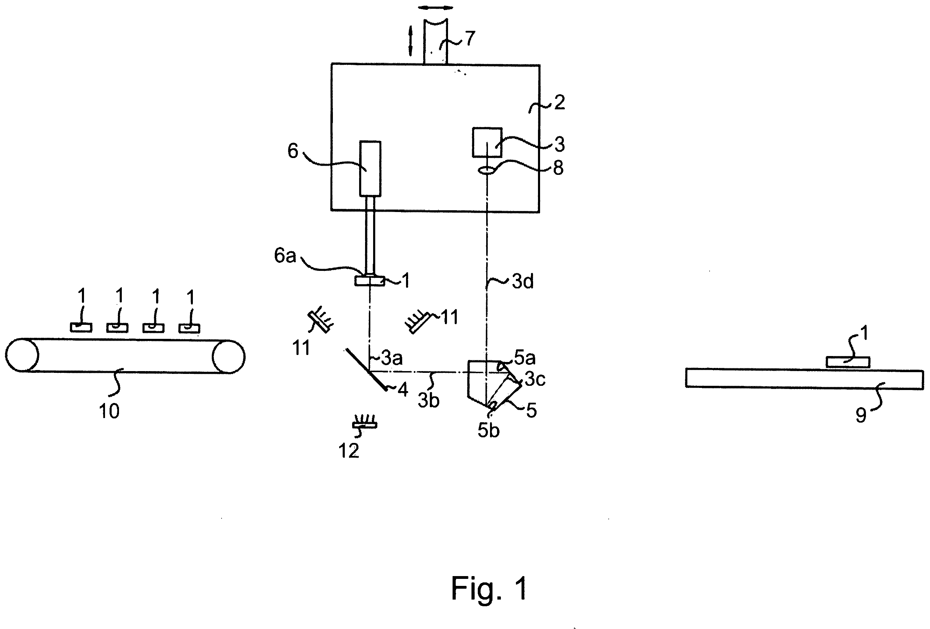

Dadurch, dass die Bildaufnahmeeinrichtung synchron mit dem Träger verstellbar ist, wird in vorteilhafter Weise erreicht, dass die Kanten des Objektes scharf abgebildet werden können und nicht mehr verwischen. Selbst bei einer relativ großen Belichtungszeit, die sich vorteilhaft auf die Schärfe der Abbildung des Objektes auswirkt, und einer relativ hohen Geschwindigkeit, mit der sich das Objekt bewegt, wird das Objekt scharf auf der Bildaufnahmeeinrichtung abgebildet. Das heißt, es entstehen keine verwischten Kanten mehr. Die Kanten des Objektes werden mit hohem Kontrast auf dem Bildaufnahmeelement der Bildaufnahmeeinrichtung abgebildet.

Erfindungsgemäß ist vorgesehen, dass der Strahlengang der Bildaufnahmeeinrichtung eine ungerade Anzahl, mindestens jedoch drei Spiegel enthält. Hierdurch lässt sich der Strahlengang so gestalten, dass er unterhalb des Greifers sowie unterhalb der Bildaufnahmeeinrichtung senkrecht verläuft und einen in einem entsprechenden Abstand von dem Greifer beziehungsweise der Bildaufnahmeeinrichtung waagerecht verlaufenden Zweig hat. Da der Strahlengang keinen schräg verlaufenden Zweig mehr hat, lässt sich der entsprechende Raum für Maschinenelemente nutzen, wodurch sich die Konstruktion der Vorrichtung einfacher gestaltet.

In vorteilhafter Weise ist die Bildaufnahmeeinrichtung auf dem Träger angeordnet. Hierdurch wird auf einfache Weise eine exakte Synchronizität der Bewegung der Bildaufnahmeeinrichtung mit der Bewegung des Objektes erreicht.

Durch die Spiegel lässt sich die Vorrichtung sehr kompakt aufbauen. Denn die Bildaufnahmeeinrichtung lässt sich neben einem auf dem verstellbaren Träger angeordneten Greifer, der das Objekt aufgenommen hat, anordnen. Dadurch, dass die Kamera nicht unterhalb des Greifers angeordnet zu werden braucht, wird eine weitere bauliche Vereinfachung der Vorrichtung erreicht.

In vorteilhafter Weise enthält der Strahlengang wenigstens ein Pentaprisma. Hierdurch vereinfacht sich der Aufbau der Vorrichtung nochmals.

Weitere Einzelheiten, Merkmale und Vorteile der vorliegenden Erfindung ergeben sich aus der nachfolgenden Beschreibung eines besonderen Ausführungsbeispiels unter Bezugnahme auf die Zeichnung.

Es zeigt die einzige Figur eine schematische Darstellung einer erfindungsgemäßen Vorrichtung.

Wie der Figur entnommen werden kann, sind auf einem als Montageplatte 2 ausgebildeten Träger ein Greifer 6 sowie eine als Kamera 3 mit einer Linse 8 ausgebildete Bildaufnahmeeinrichtung angeordnet. Die Montageplatte 2 ist an einem Arm 7 eines in der Figur nicht dargestellten Handlingsystems befestigt. Mittels des Handlingsystems lässt sich die Montageplatte 2 in senkrechter als auch in waagerechter Richtung verstellen. Statt dass die Montageplatte 2 in senkrechter Richtung verstellbar ist, kann der Greifer 6 senkrecht verstellbar ausgebildet sein. Hierdurch behält die Kamera in senkrechter Richtung ihre Position bei.

Der Greifer 6 weist einen Vakuumsauger 6a auf, mittels dem ein als elektronisches Bauelement 1 ausgebildetes Objekt am Greifer 6 gehalten wird.

Das elektronische Bauelement 1 wird vom Greifer 6 von einer als Transportband 10 ausgebildeten Vorratseinrichtung aufgenommen und auf eine Leiterplatte 9 aufgebracht.

Da die Position und die Lage der Bauelemente 1 auf dem Transportband 10 variieren, sind die Bauelemente 1 am Greifer 6 jeweils in entsprechend unterschiedlichen Positionen und Lagen angeordnet. Um zu erreichen, dass die Bauelemente 1 jeweils in einer exakten Position und Lage auf die Leiterplatte 9 aufgesetzt werden, werden die Position und Lage des am Vakuumsauger 6a angeordneten Bauelements 1 erfasst. Hierzu ist unterhalb des Greifers 6 ein erster Spiegel 4 angeordnet, der die Strahlung des vom Bauelement 1 reflektierten Lichtes, von dem lediglich der Hauptstrahl 3a dargestellt ist, um neunzig Grad umlenkt. Das vom Bauelement 1 reflektierte Licht wird von Lichtquellen 11, die seitlich des ersten Spiegels 4 und unterhalb des Bauelements 1 angeordnet sind, erzeugt. Des Weiteren kann das Licht von einer Lichtquelle 12 erzeugt werden, die unterhalb des ersten Spiegels 4 angeordnet ist. Hierbei muss der erste Spiegel 4 selbstverständlich lichtdurchlässig beziehungsweise halblichtdurchlässig sein.

Der umgelenkte Lichtstrahl 3b trifft dann auf die verspiegelte Fläche 5a einer Seite eines Pentaprismas 5, die den Lichtstrahl 3b nochmals umlenkt. Der nochmals umgelenkte Lichtstrahl 3c trifft innerhalb des Pentaprismas 5 auf eine weitere verspiegelte Fläche 5b des Pentaprismas 5, von der er nochmals umgelenkt wird. Der nochmals umgelenkte Lichtstrahl 3d verläuft wiederum senkrecht und trifft auf die Linse 8 der Kamera 3. Die Koordinaten der von der Kamera 3 aufgenommenen Abbildung des Bauelements 1 werden an eine in der Figur nicht dargestellte Steuerung übergeben, in der die Koordinaten mit Sollwerten verglichen werden. Aufgrund der Abweichung der erfassten Koordinaten von den Sollwerten werden Korrekturwerte errechnet, die an das in der Figur ebenfalls nicht dargestellte Handlingsystem übergeben werden, wodurch das Bauelement 1 positions- und lagegenau auf die Leiterplatte 9 abgesetzt werden kann.

Da die Kamera 3 und der Greifer 6 beim Überfahren der aus dem ersten Spiegel 4 und dem Pentaprisma 5 bestehenden optischen Anordnung keine Relativbewegung zueinander durchführen, wird das Bauelement 1 als ruhendes Objekt auf das Bildaufnahmeelement der Kamera 3 abgebildet. Hierdurch findet eine Verwischung der Kanten des Bauelements 1 nicht statt.

Dadurch, dass der Strahlengang 3a, 3b, 3c, 3d der Kamera 3 eine dreifache Umlenkung aufweist, führen die senkrechten Zweige 3a, 3d des Strahlengangs jeweils dieselbe waagrechte Verschiebung durch, wenn der Träger 2 und damit der Greifer 6 sowie das Bauelement 1 die aus dem ersten Spiegel 4 und dem Pentaprisma 5 bestehende optische Anordnung überstreichen.

## Patentansprüche

1. Vorrichtung zum Erfassen eines auf einem verstellbaren Träger (2) angeordneten Objektes (1), welche eine Bildaufnahmeeinrichtung (3) zur Aufnahme des Objektes (1) aufweist, wobei die Bildaufnahmeeinrichtung (3) synchron mit dem Träger (2) verstellbar ist,
**dadurch gekennzeichnet,**
**dass** der Strahlengang (3a, 3b, 3c, 3d) der Bildaufnahmeeinrichtung (3) eine ungerade Anzahl, mindestens jedoch drei Spiegel (4, 5a, 5b) enthält.

2. Vorrichtung nach Anspruch 1,
**dadurch gekennzeichnet,**
**dass** die Bildaufnahmeeinrichtung (3) auf dem Träger (2) angeordnet ist.

3. Vorrichtung nach Anspruch 1 oder 2,
**dadurch gekennzeichnet,**
**dass** der Strahlengang (3a, 3b, 3c, 3d) wenigstens ein Pentaprisma (5) enthält.

## Claims

1. Apparatus for capturing an object (1) arranged on an adjustable carrier (2), which apparatus has an image recording device (3) for recording the object (1), wherein the image recording device (3) is adjustable synchronously with the carrier (3),
**characterized**
**in that** the beam path (3a, 3b, 3c, 3d) of the image recording device (3) has an odd number of, but at least three, mirrors (4, 5a, 5b).

2. Apparatus according to Claim 1,
**characterized**
**in that** the image recording device (3) is arranged on the carrier (2).

3. Apparatus according to Claim 1 or 2,
**characterized**
**in that** the beam path (3a, 3b, 3c, 3d) includes at least one pentaprism (5).

## Revendications

1. Dispositif de détection d'un objet (1) disposé sur un support (2) réglable, lequel dispositif comporte un équipement d'acquisition d'image (3) destiné à acquérir l'objet (1), dans lequel l'équipement d'acquisition d'image (3) est réglable en synchronisme avec le support (2),
**caractérisé en ce que** le chemin de faisceau (3a, 3b, 3c, 3d) de l'équipement d'acquisition d'image (3) comporte cependant un nombre impair d'au moins trois miroirs (4, 5a, 5b).

2. Dispositif de selon la revendication 1,
**caractérisé en ce que** l'équipement d'acquisition d'image (3) est disposé sur le support (2).

3. Dispositif de selon la revendication 1 ou 2,
**caractérisé en ce que** le chemin de faisceau (3a, 3b, 3c, 3d) contient au moins un pentaprisme (5).
